# EUROPEAN PATENT SPECIFICATION

(11) **EP 2 531 013 B1**
(45) Date of publication and mention of the grant of the patent: **14.03.2018**
(21) Application number: 11183393.5
(22) Date of filing: 30.09.2011
(51) Int. Cl.: H05K 7/20

(54) **A cooling system for data centres.**
Kühlsystem für Datenzentren
Système de refroidissement pour centres de données

(30) Priority: 30.05.2011 IT MO20110140
(43) Date of publication of application: 05.12.2012
(73) Proprietor: Brennercom S.p.A., 39100 Bolzano (IT)
(72) Inventor: Mattolin, Luca, 39057 Appiano Sulla Strada Del Vino (Bolzano) (IT)
(74) Representative: Colò, Chiara

(56) References cited:
- WO-A2-02/101528
- FR-A1- 2 831 019
- US-A1- 2003 150 231
- US-A1- 2003 221 999
- US-A1- 2006 047 466
- US-A1- 2009 173 017
- US-A1- 2009 210 096
- US-A1- 2009 326 721
- US-A1- 2010 027 216
- US-A1- 2010 139 887

## Description

The present invention relates to a cooling system for data processing machine centres (data centres) (ICS-inside cooling systems). Specific reference is made to cooling electronic apparatus, for treatment (storing, processing and sorting) of data, which are collected together in groups contained in special supports of standard sizes (destined to contain standard width apparatus of 800 mm and having variable depths, generally speaking of 1000 or 1200 millimetres), commonly known as racks which in turn are contained internally of large rooms, in ordered rows, each of which can accommodate various tens of units of apparatus.

Electronic apparatus for treating data, in particular "servers", which are provided with internal fans for causing cooling air circulation, during functioning produce a considerable quantity of heat which tends to very rapidly raise their working temperature; this heat must necessarily be dispersed as the apparatus in question exhibit malfunctions (or stop functioning) with an increase in temperature. The dispersion of heat produced must further be continuous and constant as failure to remove the heat can in only a few minutes lead to malfunctioning or shutdown of the apparatus - the shutdown possibly being induced by protection systems included in the apparatus but use of which is best avoided in order to guarantee the data centres' continuity of service.

The energy consumption of these data centres, which have proliferated enormously in recent years, is very high (some statistics state that data centres absorb about 5% of the world's total electrical energy consumption); in particular energy consumption for the necessary dispersion of the heat generated by these apparatus is decidedly conspicuous.

At present some cooling systems exist for apparatus contained in racks which normally exhibit perforated walls to allow inlet of cool air and exit of hot air.

In a first system, each rack is provided with an autonomous cooling system which is directly connected to the rack walls and which, through a perforated lateral wall of the rack, injects cool air into the rack which is circulated in the apparatus by the internal fans of the apparatus, cooling the apparatus before exiting from the rack through the other perforated wall. This system is rather expensive as apart from consuming a considerable quantity of energy for the functioning of the single cooling machines, it includes use of various cooling machines and requires rooms that are much larger than those necessary for containing the racks, precisely due to the presence of the cooling system externally of each rack. Further, to prevent damage which might occur in a case of non-functioning of the cooling system, in many data centres the racks are each provided with two autonomous cooling systems, one of which functions even when the other is not functioning; this system obviously increases the above-mentioned defects.

In a further system, the rooms containing racks are provided with raised floors underneath which a space is afforded (generally used also for passage of the connecting cables of the apparatus) into which cold air generated by a central cooling system is injected (also often provided with several cooling units in order to prevent any system shut-downs). The racks are arranged in ordered rows along corridors, defined by two rows of racks; the front perforated openings of the racks face into some of the corridors (cool corridors), while in other cases the rear perforated openings face into other corridors (hot corridors).

Grids are provided on the floor of the cool corridors through which the cool air coming from the space of the raised floor exits; the cool air enters into the racks through the front perforated walls, is circulated in the apparatus by the internal fans of the apparatus, cools the apparatus and exits from the rack through the other perforated wall towards the hot corridors; aspirating systems, normally arranged in the upper part of the hot corridors, aspirate the hot air, as disclosed in the document "US 2009/326721 A1". These systems lead to a considerable waste of energy as there is a significant dispersion of cool air into the environment, production of which involves use of energy, which is not however in this case used for cooling the apparatus.

The aim of the present invention is to reduce the defects in cooling systems for apparatus present in data centres, by providing a system which enables a reduction in energy consumption required for a correct and effective cooling of the apparatus.

The system of the invention further exhibits the advantages of improving the management of the spaces in the rooms of data centres destined to contain the racks, reducing the noise levels in the rooms and improving the operating conditions of the operators working in the rooms.

Further characteristics and advantages of the present invention will more fully emerge from the detailed description that follows of a preferred but not exclusive embodiment of the system of the invention, illustrated by way of non-limiting example in the accompanying figures, in which:

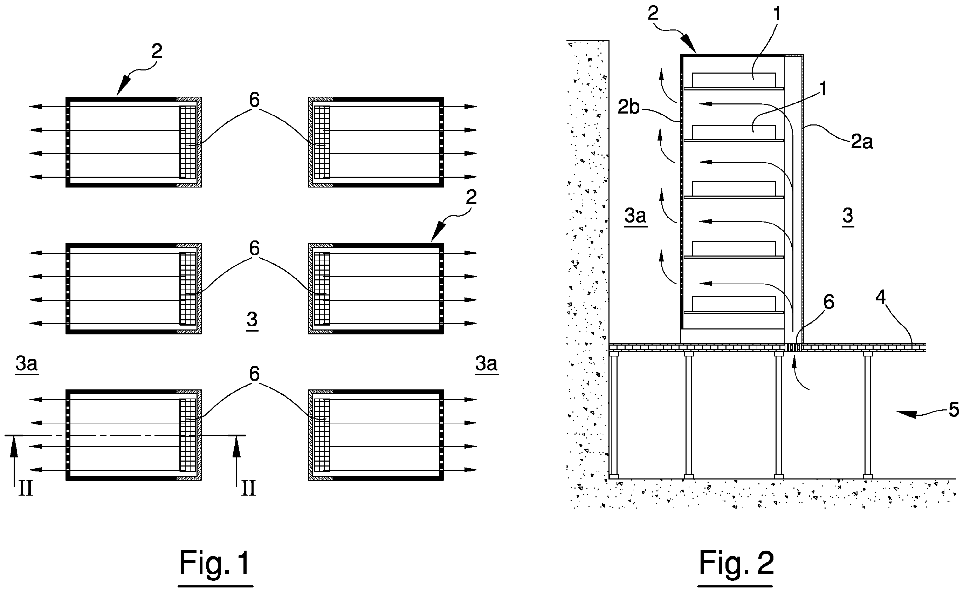

- figure 1 is a schematic view from above of some racks arranged in rows internally of a room;
- figure 2 is a schematic section, made along line II-II of figure 1, of a rack cooled by the system of the invention.

The cooling system of the invention is specifically designed to be used in centres for data centres and is destined to cool machines 1 for data processing which are contained internally of supports of standardised dimensions 2, known as racks; internally of the racks, the standard dimensions of which are comprised between 600 and 800 millimetres width and 1000 or 1200 millimetres depth, among the other devices contained are "servers", the machines which more than the others require cooling as even a slight increase in their temperature causes their malfunctioning. Both the "servers" and any other devices are made with a standard width (19 inches) and are fastened superposed on one another internally of the racks. The racks exhibit a front wall 2a and a rear wall 2b which are normally realised with an openable hatch for access to the inside of the racks.

In these centres the racks are arranged in large rooms equipped with a raised floor 4 and are flanked in ordered rows along corridors, defined "cool" 3 and "hot" 3a onto which respectively the front sides and the rear sides of the racks face.

A space 5 is afforded beneath the raised floor, in which the connecting cables of the various machines usually run; cold air generated by a central cooling system, not illustrated is introduced into the space; the cold air passes through grids 6 fashioned in the raised floor and exits from the space in order to cool the machines contained in the racks.

In the system of the invention, differently to what occurs in systems of known type in which the grids are fashioned and introduce air in the "cool" corridors, a grid 6 is fashioned internally of each rack 2, which grid 6 is arranged in the front part of the bottom of the rack and places the inside of the racks in direct communication with the space 5; the grid is fashioned in each rack arranged adheringly to the front wall of the rack, develops over a length equal to about the width of the rack (practically equal to the width of the machines contained in the rack) and has a depth which is comprised between 120 and 180 millimetres and is preferably 150 millimetres. The upper internal space of the rack is free at the grid position; for this purpose, the system of the invention preferably uses racks having a depth of 1200 millimetres.

In the system of the invention, differently to the known systems in which the front wall of the rack is perforated or in any case provided with openings, the front walls 2a of the rack are closed such that the cold air entering from the grids is conveyed to flow across the machines contained in the rack; the rear walls 2b of the racks are, like in the known systems, provided with holes or apertures for communication internally of the rack with the outside environment overlying the raised floor, such as to enable exit towards the outside (in particular in the hot corridor) of the air which has heated up as it crossed the machines. The hot air is then, like in known systems, aspirated from the environment through normal aspirating systems.

In the system of the invention, the overpressure of the cold air internally of the space is comprised between 10 and 30 millipascal and preferably is 20 millipascal.

In systems of known type the cold air is introduced into the "cool" corridors and enters in the racks through the front walls thereof which, as mentioned, are perforated. In the system of the invention, the cool air enters directly internally of the racks and in particular in the front part thereof, invades the free zone of the rack which is above the grids and flows towards the rear part of the rack, crossing and therefore cooling the machines contained therein; this crossing is made easy by the presence of cooling fans with which the "servers" are usually provided.

In the system of the invention, which enables use of a centralised production system of the cool air (with the above-indicated advantages of smaller size and lower realisation and running costs), the cool air has no leakage into the environment containing the racks, nor any contact with the hot air exiting from the rack (which occurs with known systems) but is entirely used for cooling the machines with an obvious and considerable energy saving which, from tests carried out, can be quantified as a reduction of about 25-30% of the energy necessary for cooling the machines contained in the racks.

In the following table a comparison is made of the parts at various heights of the rack, given a same temperature and overpressure of the cool air present in the space, the rising air flow velocity internally of the racks and the temperature of the air in aspiration of the servers and the temperature of the air in aspiration of the "servers" which exist in known systems (in italics) and in the system of the invention (in bold characters), both using air coming from the spaces of raised floors.

| Both systems | | Known systems | | Present System | |
|---|---|---|---|---|---|
| Position | Height from floor (mm) | Air velocity (ft/min) | Temperature of server aspiration *(C °)* | Air velocity (ft/min) | Temperature of server aspiration (C°) |
| Lower part | 500 | 0 | 21.2 | 24 | 19.4 |
| Central part | 1100 | 4 | 20.7 | 32 | 19.9 |
| Upper part | 1800 | 2 | 20.7 | 10 | 19.9 |

From the above data, a greater cooling efficiency in the system of the invention clearly emerges, with respect to the known systems which use like structures; this means that given an equal efficiency of cooling, the system of the invention enables considerable energy saving.

Thanks to that fact that the racks can be used with closed front walls (or to the fact that the front access hatches of the racks are not provided with openings for passage of the cool air), the system of the invention considerably reduces the noise levels in the rooms in which the racks are contained, as the noise of the fans on board the machines is removed; also, the flow of cold air in the "cool" corridors coming from the floor is eliminated. All of this improves the working conditions of the operators that have to work internally of the rooms the racks are located in.

The known system further improves the management of the spaces internally of the rooms as the rows of racks can be neared to one another, since the unwieldy grids present in the corridors of the known systems have been eliminated.

## Claims

1. A cooling system for data centres, of a type destined to cool machines (1) for processing data contained in standardised racks (2) in turn arranged in ordered rows along corridors (3, 3a) of environments provided with a raised floor (4), below which a space (5) is afforded into which cold air is introduced in overpressure, generated by a central cooling system, in which grids (6) are fashioned for exit of the cold air from the space, **characterised in that**: at least a grid of the said grids (6) is fashioned internally of each rack (2) which at least a grid is arranged in a front part of a bottom of the rack and places the inside of the racks in direct communication with the space (5); front walls (2a) of the racks are closed while rear walls (2b) of the racks are provided with holes for communication of an inside of the racks with an external environment overlying the raised floor.

2. The cooling system according to claim 1, **characterised in that**: in each rack the grid is arranged adheringly to the front wall and develops over a width which is about equal to a width of the rack and over a depth which is comprised between 120 and 180 millimetres; an upper internal space of the rack is free at the grid position.

3. The cooling system according to claim 1, **characterised in that** the overpressure of the cold air internally of the space is comprised between 10 and 30 millipascal.

4. The cooling system according to claim 3, **characterised in that** the overpressure of the cold air internally of the space is 20 millipascal.

## Patentansprüche

1. Kühlsystem für Datenzentren von einem Typ, der dafür bestimmt ist, Maschinen (1) zum Verarbeiten von Daten zu kühlen, die in Standardracks (2) enthalten sind, die wiederum in geordneten Reihen entlang von Gängen (3, 3a) von Umgebungen angeordnet sind, versehen mit einem angehobenen Boden (4), unter dem ein Bereich (5) ausgebildet ist, in den Kaltluft in Überdruck eingeführt werden kann, erzeugt durch ein zentrales Kühlsystem, in dem Gitter (6) für den Austritt der Kaltluft aus dem Bereich ausgebildet sind, **dadurch gekennzeichnet, dass** mindestens ein Gitter dieser Gitter (6) innenseitig in jedem Rack (2) ausgeformt ist, wobei das mindestens eine Gitter in einem Frontteil eines Bodens des Racks angeordnet ist und die Innenseite der Racks direkt mit dem Bereich (5) verbindet, wobei frontseitige Wände (2a) der Racks geschlossen sind, während Rückwände (2b) der Racks mit Löchern für die Verbindung einer Innenseite der Racks mit einer äußeren Umgebung, die über dem angehobenen Boden liegt, versehen sind.

2. Kühlsystem nach Anspruch 1, **dadurch gekennzeichnet, dass** das Gitter in einem jeden Rack anliegend an der Frontwand angeordnet ist und sich über eine Breite entwickelt, die in etwa gleich einer Breite des Racks ist, und über eine Tiefe, die zwischen 120 und 180 mm umfasst ist, wobei ein oberer innenseitiger Bereich des Racks an der Gitterposition frei ist.

3. Kühlsystem nach Anspruch 1, **dadurch gekennzeichnet, dass** der Überdruck der Kaltluft im Bereich zwischen 10 und 30 Millipascal beträgt.

4. Kühlsystem nach Anspruch 3, **dadurch gekennzeichnet, dass** der Überdruck der Kaltluft im Bereich 20 Millipascal beträgt.

## Revendications

1. Système de refroidissement pour centres de données, d'un type destiné à refroidir des machines (1) pour traiter des données contenues dans des racks standardisés (2) disposés à leur tour en rangées ordonnées le long de corridors (3, 3a) d'environnements pourvus d'un sol surélevé (4), en dessous duquel est ménagé un espace (5) dans lequel de l'air froid est introduit en surpression, généré par un système de refroidissement central, dans lequel des grilles (6) sont formées pour faire sortir de l'air froid de l'espace, **caractérisé en ce que**: au moins une grille desdites grilles (6) est formée intérieurement de chaque rack (2), dans lequel l'au moins une grille est disposée dans une partie avant d'un fond du rack et met l'intérieur des racks en communication directe avec l'espace (5); les parois avant (2a) des racks sont fermées tandis que les parois arrière (2b) des racks sont pourvues de trous pour la communication d'un intérieur des racks avec un environnement extérieur recouvrant le sol surélevé.

2. Système de refroidissement selon la revendication 1, **caractérisé en ce que**: dans chaque rack, la grille est disposée de manière adhérente à la paroi avant et s'étend sur une largeur qui est à peu près égale à une largeur du rack et sur une profondeur qui est comprise entre 120 et 180 millimètres; un espace interne supérieur du rack est libre au niveau de la position de la grille.

3. Système de refroidissement selon la revendication 1, **caractérisé en ce que** la surpression de l'air froid dans l'espace est comprise entre 10 et 30 millipascal.

4. Système de refroidissement selon la revendication 3, **caractérisé en ce que** la surpression de l'air froid à l'intérieur de l'espace est de 20 millipascal.
